(19) Europäisches Patentamt
European Patent Office
Office européen des brevets

(11) **EP 2 102 990 B1**

(12) **EUROPEAN PATENT SPECIFICATION**

(45) Date of publication and mention
of the grant of the patent:
**07.05.2014 Bulletin 2014/19**

(21) Application number: **07855600.8**

(22) Date of filing: **20.12.2007**

(51) Int Cl.:
**H04B 1/04** (2006.01)

(86) International application number:
**PCT/CA2007/002318**

(87) International publication number:
**WO 2008/074147 (26.06.2008 Gazette 2008/26)**

(54) **EDGE POWER RAMP USING LOGARITHMIC RESISTOR ATTENUATOR**

RANDAUFSTEIGSTÄRKE MIT LOGARITHMISCHEN WIEDERSTANDSDÄMPFER

VARIATION DE PUISSANCE À NORME EDGE AU MOYEN D'UN ATTÉNUATEUR À RÉSISTANCE LOGARITHMIQUE

(84) Designated Contracting States:
**AT BE BG CH CY CZ DE DK EE ES FI FR GB GR
HU IE IS IT LI LT LU LV MC MT NL PL PT RO SE
SI SK TR**

(30) Priority: **21.12.2006 US 871312 P**

(43) Date of publication of application:
**23.09.2009 Bulletin 2009/39**

(73) Proprietor: **NVIDIA Technology UK Limited
London
EC4A 3AE (GB)**

(72) Inventors:
• **HOLDEN, Alan R.**
**Mckinney, Texas 75070-6362 (US)**
• **SAFIRI, Hamid R.**
**Plano, Texas 75093 (US)**
• **FRECHETTE, Michel J.G.J.P.**
**Plano, Texas 75093 (US)**
• **EMBABI, Sherif H.K.**
**Plano, Texas 75025 (US)**
• **BELLAOUAR, Abdellatif**
**Richardson, Texas 75081 (US)**
• **DEVISON, Stephen Arnold**
**Waterloo, Ontario N2K 3Z7 (CA)**
• **MANKU, Tajinder**
**Waterloo, Ontario N2L 6M7 (CA)**

(74) Representative: **Driver, Virginia Rozanne
Page White & Farrer
Bedford House
John Street
London WC1N 2BF (GB)**

(56) References cited:
EP-A1- 0 614 269          WO-A1-01/50632
WO-A1-03/075484          WO-A1-2005/060090
WO-A2-2005/060112        US-A- 5 697 072
US-B2- 7 116 173

**Description**

**FIELD OF THE INVENTION**

The present invention relates generally to power control in radio frequency (RF) circuits. More particularly, the present invention relates to power ramping in RF circuits for use in wireless transceivers.

**BACKGROUND OF THE INVENTION**

The evolution of wireless systems includes the Enhanced Data Rates for Global Evolution (EDGE) standard. The EDGE standard is an extension of the Global System for Mobile Communications (GSM) standard and is a digital mobile phone technology that allows increased data transmission rates and improved data transmission reliability. EDGE networks can be used for any packet switched application including Internet connections. High-speed data applications such as video services and other multimedia benefit from increased data capacity. However, the rollout of new generation wireless systems presents unique challenges to mobile handset designers. In order to benefit fully from the expanded capacity and data bandwidth of new technology such as EDGE, new handsets must work on both the new systems as well as the old.

As mobile phone architectures have evolved, their power consumption and cost have decreased while their efficiency and performance have increased. Meanwhile, the wireless base stations that serve these phones have strived to keep up with these improvements. Over half of a modern base station's power consumption is associated with the power amplifier, so continuous system-level efforts are being made to improve its energy efficiency. The time division multiple access (TDMA) architectures found in GSM and EDGE systems must be capable of ramping their power envelopes up and down within prescribed limits of power versus time. If critical ramp timing is not optimally managed, information can be lost on the transmit slot or interference can be caused by transmission during the receive slot.

US 5,697,072 discloses a transmission signal level control device for a radio transmitter in a TDMA system.

EP 0614269 discloses a power amplifier for amplifying a radio frequency signal for use in GSM.

Networks including EDGE technology increases the data rate over that available with GSM by sending more bits per RF burst. More bits are sent in EDGE by using a modulation scheme based on 8-phase shift keying (8-PSK). This provides an increase over GSM's Gaussian minimum shift keying (GMSK) modulation format. In the EDGE modulation scheme, the 8-PSK constellation is rotated to avoid the problems associated with zero crossings. In contrast to GMSK's constant amplitude envelope, the added rotation factor in the EDGE modulation scheme results in a non-constant amplitude envelope. This non-constant amplitude envelope presents some difficulties with regard to RF power control. These problems are exacerbated by the desire to have one transmitter that can be used for both the GSM and EDGE standards. The EDGE system standard requires that power amplifier ramp up and down with the same speed as for GSM. Thus, the loop must have a response fast enough to provide an adequate rise time, and slow enough to avoid ringing or instability.

Known techniques for power ramping include providing a high-speed current-output digital to analog converter (DAC) that can be used with a single op amp to generate a ramp profile that fits the RF gain requirements. The ramp is applied to the voltage control pin of a variable-gain amplifier (VGA) to control the gain of the RF signal. Specifying the offset, rise time, fall time, amplitude profile, and period information allows the DAC to curve fit the desired ramp. This profile information can be stored in microprocessor control logic. However, this solution can be costly to implement.

WO 03/075484 discloses a power control device for controlling the transmission power of a transmitter in a mobile communication network in which burst signals are applied to the transmitter.

WO 01/50632 discloses sending messages in the form of bursts wherein the output power level is measured at certain instances of the burst to adjust the power level in the next burst.

It is therefore, desirable to provide cost effective power ramping in RF circuits for transmitting signals used in wireless applications.

**SUMMARY OF THE INVENTION**

It is an object of the present invention to obviate or mitigate at least one disadvantage of previous power ramping techniques in RF circuits for transmitting signals used in wireless applications including mobile handset terminals.

In a first aspect, the present invention provides a power ramping circuit for a wireless transmit circuit, comprising: a diode connected transistor, a voltage to current converter for converting an input base band voltage signal (IN) to a corresponding input current and connected to provide the input current to the diode connected transistor; wherein the diode connected transistor is coupled between the voltage to current converter and a voltage supply and comprises an input terminal, for receiving the input current an input transistor connected in a current mirror configuration with the diode connected transistor the input transistor comprising a drain terminal for providing a data signal comprising an output current and a source terminal coupled to the voltage supply; and a plurality of controlled resistance elements, coupled between the voltage supply and a gate terminal of the input transistor; a ramp control circuit for ramping the output current from a minimum magnitude to a maximum magnitude by sequentially turning off each of the controlled resistance elements. In an embodiment of the present aspect, the power ramping circuit can include a first order filter having a resistor connected between the gate terminal of the input transistor and the diode connected transistor, and a capacitor coupled between the gate terminal of the input transistor and the voltage supply.

According to another embodiment of the present aspect, the plurality of controlled resistance elements include a plurality of parallel connected transistors, where all of the plurality of parallel connected transistors are sized differently from each other. More particularly, each of the plurality of parallel connected transistors are sized to have different W/L dimensions, where W is a width and L is a length of each of the plurality of parallel connected transistors, which can be turned off in order of increasing size. In an aspect of the present embodiment, the plurality of parallel connected transistors each include a gate terminal coupled to a corresponding gate control signal of the ramp control circuit, for sequentially turning off each one of said plurality of parallel connected transistors. The ramp control circuit can include an analog to digital (A/D) converter and a digital decoder. The A/D converter provides a digital output corresponding to an analog control signal. The digital decoder selectively turns off each one of said plurality of parallel connected transistors in response to the digital output from the A/D converter. Alternately, the ramp control circuit can include a counter and a digital decoder. The counter provides a digital output corresponding to counted edges of an oscillating signal. The digital decoder selectively turns off each one of said plurality of parallel connected transistors in response to the digital output from the counter.

In a second aspect, the present invention provides a method of ramping a data signal comprising an output current within a wireless transceiver, said method comprising: converting an input base band voltage signal (IN) to a corresponding input current; providing said input current to a diode connected transistor, mirroring the input current by means of an input transistor connected in a current mirror configuration with the diode connected transistor; turning on each of a plurality of controlled resistance elements coupled between a voltage supply and a gate terminal of the input transistor to minimize a magnitude of the output current provided by a drain terminal of the input transistor which corresponds to the base-band voltage signal; and sequentially turning off each of the controlled resistance elements for increasing the magnitude of the output current provided by the drain terminal of the input transistor.

According to an embodiment of the present aspect, the step of sequentially turning off includes receiving a ramp control signal; converting the ramp control signal into a digital output; and decoding the digital output to turn off at least one of the parallel connected transistors. In an aspect of the present embodiment, the ramp control signal is a ramped analog voltage level and the step of converting includes executing analog to digital conversion to provide the digital output corresponding to the analog voltage level at a predetermined frequency. Alternately, the ramp control signal is an oscillating clock signal and the step of converting includes counting active edges of the oscillating clock signal with a counter to provide the digital output corresponding a value of the counter.

Other aspects and features of the present invention will become apparent to those ordinarily skilled in the art upon review of the following description of specific embodiments of the invention in conjunction with the accompanying figures.

## BRIEF DESCRIPTION OF THE DRAWINGS

Embodiments of the present invention will now be described, by way of example only, with reference to the attached Figures, wherein:

> Figure 1 is a block diagram of a transmit path circuit incorporating the present invention.
> Figure 2 is a graphical depiction of the ramping function of the present invention.
> Figure 3 is a circuit diagram of the ramping circuit in accordance with the present invention.
> Figure 4 is a block diagram of ramp control elements using an analog control voltage in accordance with the present invention.
> Figure 5 is a block diagram of ramp control elements using a digital control voltage in accordance with the present invention
> Figure 6 is a plot of ramp transistor gate voltages versus an analog ramp control voltage; and,
> Figure 7 is a circuit schematic of a ramp control circuit for generating analog ramp control voltages.

## DETAILED DESCRIPTION

Generally, the present invention provides a method and apparatus for power ramping in an RF transmit circuit. A transmit circuit of a wireless transceiver for transmitting signals incorporating the present invention may be used in mobile handset terminals for wireless applications. In particular, the present invention includes a logarithmic resistor attenuator for power ramping.

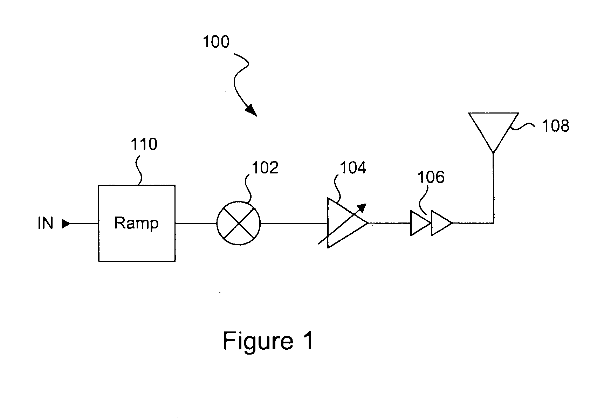

With reference to Figure 1, there is shown a generalized block diagram of transmit path circuits incorporating the present invention. Typically, the transmit path is designed to provide the required level of performance at the worst-case output power level. The transmit signal path 100 includes several elements known to one of ordinary skill in the art of RF circuitry to be standard RF transmit components. Such elements include a mixer 102, a variable gain amplifier (VGA) 104, a power amplifier 106, and an antenna 108. Such specific transmitter design advantageously employs the power ramping techniques described herein. However, it should be understood that various modifications may be made to the particular arrangement shown in Figure 1. For example, fewer or additional filters, buffers, and amplifier stages may be provided in the transmit signal path 100. Moreover, the elements within the transmit signal path 100 may be arranged in different configurations. Further, variable gain in the transmit signal path 100 may be provided by a VGA as shown, or alternatively by variable attenuators, multipliers, other variable gain elements, or a combination thereof. In alternative transmitter designs, a direct upconversion architecture may be used where the power amplifier receives a modulated RF signal directly. In general, the power ramping techniques described herein are used for a transmit path regardless of how the modulated RF signal is generated.

Generally, the transmit circuit of the transmit signal path 100 receives a data signal "IN" and up-converts such signal to a carrier frequency via mixer 102. The signal gain is then adjusted by VGA 104 and then output through power amplifier 106 prior to carrier transmission as a data signal via antenna 108. As mixer 102, VGA 104, power amplifier 106, and antenna 108 and their functions are well known to those skilled in the RF circuitry art, they will not be further specifically detailed. Within the present invention however, the necessary rate of power increase of the signal "IN" is provided to the mixer 102 in an inventive manner.

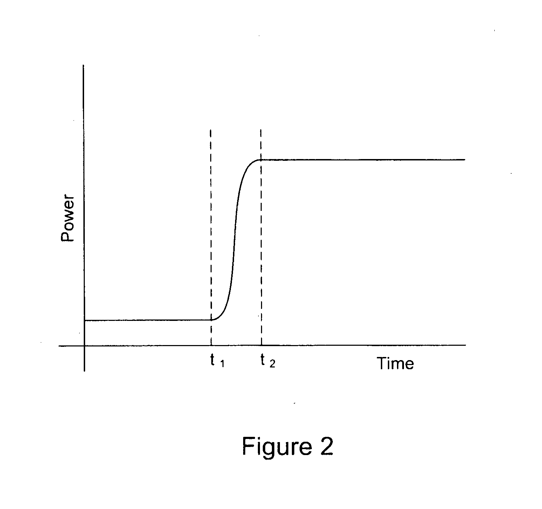

According to an embodiment of the present invention, power ramping of a base band signal "IN" is controlled by a power ramping circuit 110 as seen in Figure 1. The power ramping circuit 110 controls the rate of power increase of the signal thus provided to the input of the mixer 102. As shown in Figure 2, the function of power ramping circuit 110 is illustrated. From the graph it can be seen that power is minimal prior to time $t_1$ and at time $t_2$ ramps up to maximum power at which time a signal is to be transmitted. Thus, the power ramping circuit 110 will gradually and linearly increase the power until time $t_2$ when the maximum power is attained.

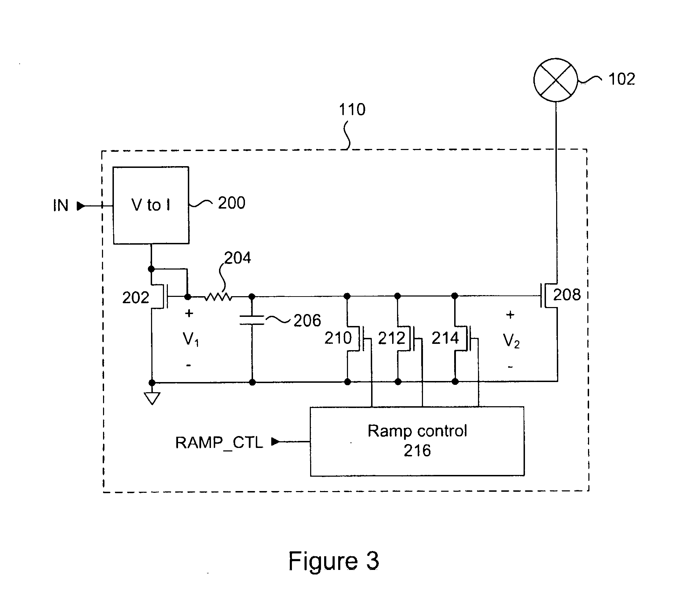

Figure 3 is a circuit embodiment of the power ramping circuit 110 which can be considered a pre-amplifier circuit for providing a preconditioned data signal to the mixer 102. The power ramping circuit 110 includes a voltage to current (V-I) converter 200 for converting the input signal "IN" to a current. This current is passed through a first order filter formed by a diode connected n-channel transistor 202 with resistor 204 and capacitor 206 elements. An input transistor 208 is connected to the other end of the resistor, which is connected to an input of the mixer 102 of Figure 1. The gate of input transistor 208 receives an input data signal corresponding to the current provided by V-I converter 200, which itself corresponds to input signal "IN". The n-channel transistor 202 and the input transistor 208 are arranged in a current mirror configuration where transistor 202 has an input terminal for receiving a current corresponding to "IN" and transistor 208 has an output terminal for providing an output current. Therefore the current through n-channel transistor 202 will be mirrored in input transistor 208, provided that n-channel transistor 202, input transistor 208 are identically sized and the voltage on their gates is unchanged. However, connected in parallel with the capacitor element 206 are scaled ramp transistors 210, 212, and 214, each having a gate controlled by ramp control circuit 216 for selectively coupling the gates of transistors 202 and 208 to VSS. Although three transistors are shown, it should be understood that there can be any number of ramp transistors without straying from the intended scope of the present invention.

The transistors 210, 212, and 214 serve as parallel controlled resistance elements, which collectively function as a single controlled resistance element. Therefore, resistor 204 and the parallel controlled resistance elements are arranged in a voltage divider configuration for controlling input transistor 208. By controlling the gates of the transistors 210, 212 and 214 by way of ramp control circuit 216, the combined resistive value of the transistors 210, 212 and 214 can be changed, thereby changing the voltage on the gate of input transistor 208. It is noted that transistors are turned on by driving their gate terminals with an active signal, whereas they are turned off by driving their gate terminals with an inactive signal. An active signal is one that has a voltage level sufficient for turning on the transistor. As the resistive value rises, then input transistor 208 will be progressively turned on so as to feed the mixer element 102 with more and more current. This effectively controls the gain from $V_1$ to $V_2$. It should therefore be readily apparent that timing the gate control and selectively turning on each transistor 210, 212, and 214 will therefore provide a controlled ramping of the signal to the mixer element 102. Still further, each ramp transistor 210, 212 and 214 can be scaled in size. For example, ramp transistor 210 is sized to have a width-to-length (W/L) ratio of W1/L1. Then transistor 212 can have a size of W2/L2 and transistor 214 can have a size of W3/L3. In accordance with the present invention, each ramp transistor 210, 212 and 214 is sized differently from the other in a predetermined pattern. By example, there can be a scaling factor of two for each successive ramp transistor. Using the present example, W2/L2 = 2W1/L2. The length dimension of the ramp transistors can remain constant, such that L1=L2=L3.

In operation of the present invention, it is assumed that all ramp transistors 210, 212, and 214 are turned on to maintain the gate of the input transistor 208 as grounded when no signal transmission is occurring. When signal transmission commences and signal IN is received by V-I converter **200,** The ramp control circuit **216** will turn off the first ramp transistor **210,** followed by the next transistor **212** and so forth, until all ramp transistors **210, 212,** and **214** are turned off. It should be noted that each ramp transistor **210, 212** and **214** is operated in the linear region and controlled to provide a logarithmic function with linear input control voltage, thereby providing a linear ramping profile of the input signal to the mixer **102.** This logarithmic function correlates to the step size in decibels (dB) where the total attenuation from $V_1$ to $V_2$ is the sum of each dB step. The step size in dB from ramp transistors **210** to **212** is shown by Equation 1, using the example embodiment of Figure 3.

$$20 * \log ((W2/L2) / (W1/L1)) \qquad \text{Eq. 1}$$

The step size in dB from ramp transistors 212 to 214 is shown by Equation 2.

$$20 * \log ((W3/L3) / (W2/L2)) \qquad \text{Eq. 2}$$

The total attenuation from $V_1$ to $V_2$ where three transistors are used is shown by Equation 3.

$$(20 * \log ((W2/L2) / (W1/L1))) + (20 * \log ((W3/L3) / (W2/L2))) \qquad \text{Eq. 3}$$

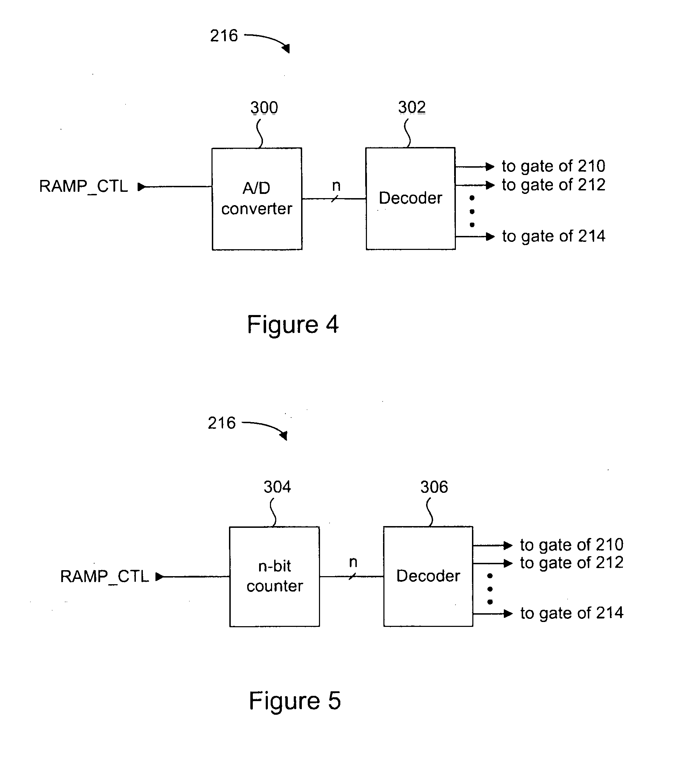

The ramp control circuit **216** may be driven by either an analog or digital ramp control signal, **RAMP_CTL.** In response to **RAMP_CTL,** ramp control circuit **216** will generate the signals for turning on or off ramp transistors **212** to **214.** Figure 4 is a block diagram of an implementation embodiment of ramp control circuit **216** when the ramp control signal is analog, whereas Figure 5 is a block diagram of an implementation embodiment of the ramp control circuit **216** when the ramp control signal is digital.

In the instance whereby ramp control circuit **216** receives an analog control signal, the ramp control circuit **216** will include an analog to digital (A/D) converter **300** and a digital decoder **302** as shown in Figure 4. It should be understood that the A/D converter **300** may be of any particular type. The analog signal **RAMP_CTL,** can be a voltage for example, can range between a low voltage level and a high voltage level. In one embodiment, **RAMP_CTL** may be initially at the low voltage level and is gradually ramped up to the high voltage level. Alternatively, **RAMP_CTL** may be initially at the high voltage level and then gradually ramped down to the low voltage level. In either scenario, the A/D converter **300** receives the analog control voltage and will output an n-bit digital signal where n is an integer selected for the desired resolution of A/D converter 300.

For each sampled voltage level of **RAMP_CTL,** the resulting n-bit digital signal provided by A/D converter **300** is subsequently decoded by a digital decoder 302. Digital decoder **302** will having logic decoding circuits configured for turning off at least one of the ramp transistors **210, 212** and **108** in response to the bit pattern of the n-bit digital signal. Therefore, as **RAMP_CTL** is ramped low to high (or high to low), different n-bit digital signals are generated synchronously with a sampling clock (not shown). Digital decoder **302** will successively turn off and keep turned off, each of the ramp transistors. In the specific embodiment of Figure 3 for example, ramp transistors **210, 212** and **214** will be turned off in this ordered sequence. Digital decoding to achieve this desired result is well known in the art, and details of its implementation will not be discussed. When the transmission operation is completed, **RAMP_CTL** can be reset and all ramp transistors **210, 212** and **214** are turned on.

In an alternate example, if n=3 A/D converter **300** will provide a 3-bit output corresponding to a sampled voltage level of the input, then the decoder would be configured to provide $2^n = 2^3 = 8$ output signals. As suggested above, it should therefore be readily apparent that each output signal from the digital decoder **302** controls the gate of one power ramping transistor, for a total of 8 ramping transistors. In this analog technique, the A/D converter **300** would sample at a predetermined frequency based on a clock signal and such frequency would preferably be faster than the system clock. The rate at which the digital decoder 302 changes its output depends upon the frequency at which the A/D converter **300** samples the analog voltage.

In the instance whereby ramp control circuit **216** receives a digital control signal, **RAMP_CTL** can be a digital clock signal (CLK) used to feed an n-bit counter **304** as shown in Figure 5. In this embodiment, n is an integer selected for the number of ramp transistors to be controlled, for example $2^n$ ramp transistors. The counter **304** will increment the n-bit output sequence on each rising or falling edge of the oscillating clock signal **(RAMP_CTL).** Accordingly, the n-bit output sequence will gradually increase in value with each counted clock edge. As before, a digital decoder **306** receives the n-bit output sequence and decodes it to turn off the required ramping transistors as the binary value of the counter increases. The rate at which the digital decoder **306** changes its output depends upon the frequency of **RAMP_CTL.**

For both the analog and digital control signal techniques as shown in Figure 4 and Figure 5, there is minimum overlap between transistors turning off. That is to say, the timing is set so that each transistor **210, 212,** and **214** is sequentially turned off which is easily accomplished by way of the digital decoder 306. Both the embodiments shown in Figures 4 and 5 provide digital outputs for controlling ramp transistors **210, 212,** and **214.** However, analog control over the gate voltages of ramp transistors **210, 212,** and **214** can be used to control the rate of power increase of the input signal provided to mixer **102** of Figure 3.

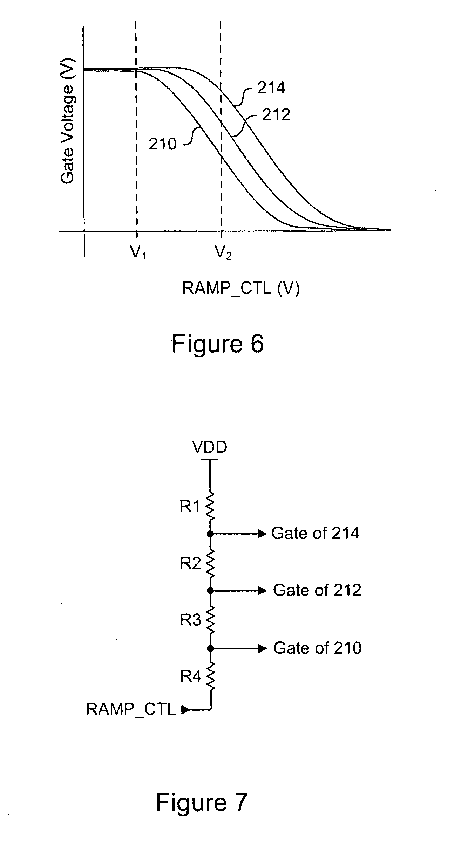

Figure 6 is an example plot of the gate voltages of ramp transistors **210, 212,** and **214** versus the analog ramp control voltage **RAMP_CTL.** This example plot shows that the gate voltage applied to ramp transistors **210, 212,** and **214** are different from each other as **RAMP_CTL** increases in magnitude. This is an example of overlap between transistors turning off, meaning that at least two transistors are transitioning to the off state at the same time, but at different rates. As shown in Figure 6, when **RAMP_CTL** is substantially zero volts, the gate voltages applied to ramp transistors **210, 212,** and **214** are at substantially maximum levels. As **RAMP_CTL** increases, the gate voltage of transistor **210** is the first to decrease at **RAMP_CTL** = V1, followed by the gate voltages of transistors **212** and **214.** As can be seen at **RAMP_CTL** = V2, all three transistors are still on. When **RAMP_CTL** reaches a predetermined maximum level, all ramp transistors will be turned off. Such type of ramp control can be implemented with different circuit techniques that are known in the art.

An example circuit embodiment for providing analog outputs for controlling ramp transistors **210, 212,** and **214** is shown in Figure 7. The ramp control circuit of Figure 7 consists of a resistor network, or a voltage divider consisting of series connected resistor elements R1, R2, R3 and R4 connected between the voltage supply and **RAMP_CTL.** The common node of R1 and R2 is connected to the gate of transistor **214,** the common node of R2 and R3 is connected to the gate of transistor **212,** and the common node of R3 and R4 is connected to the gate of transistor **210.** These common nodes can be referred to as voltage taps. In this configuration, as **RAMP_CTL** increases from VSS to some predetermined maximum level, the gate voltages will progressively decrease. The values of resistor elements R1, R2, R3 and R4 can be selected to obtain the voltage curves similar to those shown in Figure 6.

Those skilled in the art will understand that the polarity of the voltage divider of Figure 7 can be reversed, such that R1 receives the analog **RAMP_CTL** voltage, while R4 is connected to VSS. Hence the ramp transistors are all turned on by keeping **RAMP_CTL** at a high voltage level such as VDD, and then reducing **RAMP_CTL** to gradually turn off each of the ramp transistors. Accordingly, the gate control curves would be inverted relative to those shown in Figure 6.

The above-described embodiments of the present invention are intended to be examples only. Alterations, modifications and variations may be effected to the particular embodiments by those of skill in the art without departing from the scope of the invention, which is defined solely by the claims appended hereto.

**Claims**

1. A power ramping circuit (110) for a wireless transmit circuit, comprising:

   a diode connected transistor (202);
   a voltage to current converter (200) for converting an input base band voltage signal (IN) to a corresponding input current and connected to provide the input current to the diode connected transistor (202);
   wherein the diode connected transistor (202) is coupled between the voltage to current converter (200) and a voltage supply and comprises an input terminal, for receiving the input current;
   an input transistor (208) connected in a current mirror configuration with the diode connected transistor (202) the input transistor comprising a drain terminal for providing a data signal comprising an output current and a source terminal coupled to the voltage supply; and
   a plurality of controlled resistance elements (210, 212, 214), coupled between the voltage supply and a gate terminal of the input transistor (208);
   a ramp control circuit (216) for ramping the output current from a minimum magnitude to a maximum magnitude by sequentially turning off each of the controlled resistance elements (210, 212, 214).

2. The power ramping circuit (110) as claimed in claim 1, wherein the power ramping circuit includes a filter connected in parallel to the controllable resistance elements (210, 212, 214).

3. The power ramping circuit (110) as claimed in claim 2, wherein the filter is a first order filter having a resistor (204) connected between the gate terminal of the input transistor (208) and the diode connected transistor (202), and

a capacitor (206) coupled between the gate terminal of the input transistor and the voltage supply.

4. The power ramping circuit (110) as claimed in claim 3, wherein the resistor (204) of the first order filter and the plurality of controlled resistance elements (210, 212, 214) form a voltage divider.

5. The power ramping circuit (110) as claimed in claim 1, wherein said plurality of controlled resistance elements (210, 212, 214) include a plurality of parallel connected transistors.

6. The power ramping circuit (110) as claimed in claim 5, wherein all of the plurality of parallel connected transistors are sized differently from each other.

7. The power ramping circuit (110) as claimed in claim 6, wherein each of the plurality of parallel connected transistors are sized to have different W/L dimensions, where W is a width of each of the plurality of parallel connected transistors and L is a length of each of the plurality of parallel connected transistors.

8. The power ramping circuit (110) as claimed in claim 7, wherein the ramp control (216) circuit is adapted to turn off the plurality of parallel connected transistors in order of increasing size.

9. The power ramping circuit (110) as claimed in claim 5, wherein said plurality of parallel connected transistors each include a gate terminal coupled to a corresponding gate control signal of the ramp control circuit (216) and the ramp control circuit is adapted to sequentially turn off each one of said plurality of parallel connected transistors.

10. The power ramping circuit (110) as claimed in claim 5, wherein said plurality of parallel connected transistors each include a gate terminal coupled to a ramp control circuit (216), said ramp control circuit including a voltage divider circuit connected between a voltage supply and an analog control signal, the voltage divider circuit having voltage taps each coupled to each one of the plurality of parallel connected transistors.

11. The power ramping circuit (110) as claimed in claim 9, wherein said ramp control circuit (216) includes
an analog to digital (A/D) converter (300) for providing a digital output corresponding to an analog control signal, and
a digital decoder (302) for selectively turning off each one of said plurality of parallel connected transistors in response to the digital output from the A/D converter.

12. The power ramping circuit (110) as claimed in claim 9, wherein said ramp control circuit (216) includes
a counter (304) for providing a digital output corresponding to counted edges of an oscillating signal, and
a digital decoder (306) for selectively turning off each one of said plurality of parallel connected transistors in response to the digital output from the counter.

13. A method of ramping a data signal comprising an output current within a wireless transceiver, said method comprising:

converting an input base band voltage signal (IN) to a corresponding input current;
providing said input current to a diode connected transistor (202);
mirroring the input current by means of an input transistor (208) connected in a current mirror configuration with the diode connected transistor (202);
turning on each of a plurality of controlled resistance elements (210, 212, 214) coupled between a voltage supply and a gate terminal of the input transistor (208) to minimize a magnitude of the output current provided by a drain terminal of the input transistor (208) which corresponds to the base-band voltage signal; and
sequentially turning off each of the controlled resistance elements (210, 212, 214) for increasing the magnitude of the output current provided by the drain terminal of the input transistor (208).

14. The method as claimed in claim 13, wherein the step of sequentially turning off includes
receiving a ramp control signal (RAMP-CTRL),
converting the ramp control signal into a digital output (n), and
decoding the digital output to turn off at least one of the controlled resistance elements (210, 212, 214).

15. The method as claimed in claim 14, wherein the ramp control signal is a ramped analog voltage level and the step of converting includes executing analog to digital conversion (300) to provide the digital output corresponding to the analog voltage level at a predetermined frequency.

**16.** The method as claimed in claim 14, wherein the ramp control signal is an oscillating clock signal and the step of converting includes counting active edges of the oscillating clock signal with a counter (302) to provide the digital output corresponding a value of the counter.

**17.** The method as claimed in claim 13, wherein the step of sequentially turning off includes
receiving an analog ramp control signal, and,
turning off at least two of the controlled resistance elements at different rates and at the same time in response to the ramp control signal.

**Patentansprüche**

**1.** Leistungsrampenschaltung (110) für eine drahtlose Sendeschaltung, umfassend:

einen als Diode geschalteten Transistor (202);
einen Spannungs-Strom-Wandler (200) zum Umwandeln eines Eingangsbasisband-Spannungssignals (IN) in einen entsprechenden Eingangsstrom und angeschlossen, um den Eingangsstrom zum als Diode geschalteten Transistor (202) bereitzustellen;
wobei der als Diode geschaltete Transistor (202) zwischen dem Spannungs-Strom-Wandler (200) und einer Spannungsversorgung gekoppelt ist und eine Eingangsklemme zum Empfangen des Eingangsstroms umfasst;
einen Eingangstransistor (208), der in einer Stromspiegelkonfiguration mit dem als Diode geschalteten Transistor (202) angeschlossen ist, wobei der Eingangstransistor eine Drainklemme zum Bereitstellen eines Datensignals umfasst, die einen Ausgangsstrom und eine an die Spannungsversorgung gekoppelte Sourceklemme umfasst; und
eine Vielzahl von gesteuerten Widerstandselementen (210, 212, 214), die zwischen der Spannungsversorgung und einer Gateklemme des Eingangstransistors (208) gekoppelt ist;
eine Rampensteuerschaltung (216) zum Rampen des Ausgangsstroms von einer minimalen Größe zu einer maximalen Größe durch sequenzielles Abschalten jedes der gesteuerten Widerstandselemente (210, 212, 214).

**2.** Leitungsrampenschaltung (110), wie in Anspruch 1 beansprucht, wobei die Leistungsrampenschaltung ein Filter einschließt, das zu den gesteuerten Widerstandselementen (210, 212, 214) parallel geschaltet ist.

**3.** Leistungsrampenschaltung (110), wie in Anspruch 2 beansprucht, wobei das Filter ein Filter erster Ordnung ist, das aufweist:

einen Widerstand (204) der zwischen der Gateklemme des Eingangstransistors (208) und dem als Diode geschalteten Transistor (202) angeschlossen ist, und
einen Kondensator (206) der zwischen die Gateklemme des Eingangstransistors und die Spannungsversorgung gekoppelt ist.

**4.** Leistungsrampenschaltung (110), wie in Anspruch 3 beansprucht, wobei der Widerstand (204) des Filters erster Ordnung und die Vielzahl von gesteuerten Widerstandselementen (210, 212, 214) einen Spannungsteiler bilden.

**5.** Leistungsrampenschaltung (110), wie in Anspruch 1 beansprucht, wobei die besagte Vielzahl gesteuerter Widerstandselemente (210, 212, 214) eine Vielzahl parallel geschalteter Transistoren einschließt.

**6.** Leistungsrampenschaltung (110), wie in Anspruch 5 beansprucht, wobei all der Vielzahl parallel geschalteter Transistoren unterschiedlich voneinander bemessen sind.

**7.** Leistungsrampenschaltung (110), wie in Anspruch 6 beansprucht, wobei jeder der Vielzahl parallel geschalteter Transistoren bemessen ist, verschiedene B/L-Abmessungen zu haben, wobei B die Breite jedes der Vielzahl parallel geschalteter Transistoren und L eine Länge jedes der Vielzahl parallel geschalteter Transistoren ist.

**8.** Leistungsrampenschaltung (110), wie in Anspruch 7 beansprucht, wobei die Rampensteuerschaltung (216) angepasst ist, die Vielzahl parallel geschalteter Transistoren in der Reihenfolge zunehmender Größe abzuschalten.

**9.** Leistungsrampenschaltung (110), wie in Anspruch 5 beansprucht, wobei die besagte Vielzahl parallel geschalteter Transistoren jeweils eine Gateklemme einschließt, die an ein entsprechendes Gatesteuersignal der Rampensteuerschaltung (216) gekoppelt ist und die Rampensteuerschaltung angepasst ist, einen jeden der besagten Vielzahl parallel geschalteter Transistoren sequenziell abzuschalten.

10. Leistungsrampenschaltung (110), wie in Anspruch 5 beansprucht, wobei die besagte Vielzahl parallel geschalteter Transistors jeweils eine Gateklemme einschließt, die an eine Rampensteuerschaltung (216) gekoppelt ist, wobei die besagte Rampensteuerschaltung eine Spannungsteilerschaltung einschließt, die zwischen einer Spannungsversorgung und einem analogen Steuersignal angeschlossen ist, wobei die Spannungsteilerschaltung Spannungsabgriffe aufweist, die an einen jeden der Vielzahl parallel geschalteter Transistoren gekoppelt sind.

11. Leistungsrampenschaltung (110), wie in Anspruch 9 beansprucht, wobei die besagte Rampensteuerschaltung (216) einschließt:

einen (A/D) Analog-Digital-Wandler (300) zum Bereitstellen einer digitalen Ausgabe, die einem analogen Steuersignal entspricht, und
einen digitalen Decodierer (302) zum selektiven Abschalten eines jeden der besagten Viehzahl parallel geschalteter Transistoren, als Reaktion auf die digitale Ausgabe ab dem A/D-Wandler.

12. Leistungsrampenschaltung (110), wie in Anspruch 9 beansprucht, wobei die besagte Rampensteuerschaltung (216) einschließt:

einen Zähler (304) zum Bereitstellen einer digitalen Ausgabe, die gezählten Rändern eines oszillierenden Signals entspricht, und
einen digitalen Decodierer (306) zum selektiven Abschalten eines jeden der besagten Viehzahl parallel geschalteter Transistoren, als Reaktion auf die digitale Ausgabe ab dem Zähler.

13. Verfahren zum Rampen eines Datensignals, das einen Ausgangsstrom innerhalb eines drahtlosen Transceivers umfasst, wobei das besagte Verfahren umfasst:

Umwandeln eines Eingangsbasisband-Spannungssignals (IN) in einen entsprechenden Eingangsstrom;
Bereitstellen des besagten Eingangsstroms an einen als Diode geschalteten Transistors (202);
Spiegeln des Eingangsstrommittels eines Eingangstransisors (208), der in einer Stromspiegelkonfiguration mit dem als Diode geschalteten Transistor (202) verbunden ist.
Einschalten jedes einer Vielzahl von gesteuerten Widerstandselementen (210, 212, 214), die zwischen einer Spannungsversorgung und einer Gateklemme des Eingangstransistors (208) gekoppelt sind, um eine Größenordnung des Ausgangsstroms zu minimieren, der von einer Drainklemme des Eingangstransistors (208) bereitgestellt wird, der dem Basisband-Spannungssignal entspricht; und
sequenzielles Abschalten jedes der gesteuerten Widerstandselemente (210, 212, 214) zum Erhöhen der Größenordnung des Ausgangsstroms, der von der Drainklemme des Eingangstransistors (208) bereitgestellt wird.

14. Verfahren, wie in Anspruch 13 beansprucht, wobei der Schritt der sequenziellen Abschaltung einschließt:

Empfangen eines Rampensteuersignals (RAMP-CTRL),
Umwandeln des Rampensteuersignals in eine digitale Ausgabe (n), und
Decodieren der digitalen Ausgabe, um zumindest eins der gesteuerten Widerstandselemente (210, 212, 214) abzuschalten.

15. Verfahren, wie in Anspruch 14 beansprucht, wobei das Rampensteuersignal ein rampenförmiger analoger Spannungspegel ist und der Schritt der Umwandlung das Ausführen der Analog-Digital-Wandlung (300) einschließt, um die digitale Ausgabe entsprechend des analogen Spannungspegels mit einer vorgegebenen Frequenz bereitzustellen.

16. Verfahren, wie in Anspruch 14 beansprucht, wobei das Rampensteuersignal ein oszillierendes Taktsignal ist und der Schritt der Umwandlung das Zählen aktiver Ränder des oszillierenden Taktsignals mit einem Zähler (302) einschließt, um die digitale Ausgabe entsprechend eines Werts des Zählers bereitzustellen.

17. Verfahren, wie in Anspruch 13 beansprucht, wobei der Schritt der sequenziellen Abschaltung einschließt:

Empfangen eines analogen Rampensteuersignals, und,

Abschalten zumindest zwei der gesteuerten Widerstandselemente mit verschiedenen Raten und gleichzeitig als Reaktion auf das Rampensteuersignal.

**Revendications**

1. Circuit de variation de puissance (110) pour un circuit de transmission sans fil, comportant :

   un transistor monté en diode (202) ;
   un convertisseur tension/courant (200) destiné à convertir un signal de tension de la bande de base d'entrée (IN) en un courant d'entrée correspondant et connecté à des fins de fourniture du courant d'entrée au transistor monté en diode (202) ;
   dans lequel le transistor monté en diode (202) est couplé entre le convertisseur tension/courant (200) et une tension d'alimentation et comporte une borne d'entrée, à des fins de réception du courant d'entrée ;
   un transistor d'entrée (208) connecté en une configuration de miroir de courant avec le transistor monté en diode (202), le transistor d'entrée comportant une borne du drain à des fins de fourniture d'un signal de données comportant un courant de sortie et une borne de la source couplée à la tension d'alimentation ; et
   une pluralité d'éléments résistifscommandés (210, 212, 214), couplés entre la tension d'alimentation et une borne de la grille du transistor d'entrée (208) ;
   un circuit de commande de variation (216) à des fins de variation du courant de sortie d'une intensité minimale à une intensité maximale en coupant de manière séquentielle chacun des éléments résistifscommandés (210, 212, 214).

2. Circuit de variation de puissance (110) selon la revendication 1, dans lequel le circuit de variation de puissance comprend un filtre connecté en parallèle aux éléments résistifscommandés (210, 212, 214).

3. Circuit de variation de puissance (110) selon la revendication 2, dans lequel le filtre est un filtre de premier ordre ayant une résistance (204) connectée entre la borne de la grille du transistor d'entrée (208) et le transistor monté en diode (202), et
   un condensateur (206) couplé entre la borne de la grille du transistor d'entrée et la tension d'alimentation.

4. Circuit de variation de puissance (110) selon la revendication 3, dans lequel la résistance (204) du filtre de premier ordre et la pluralité d'éléments résistifscommandés (210, 212, 214) forment un diviseur de tension.

5. Circuit de variation de puissance (110) selon la revendication 1, dans lequelles éléments de ladite pluralité d'éléments résistifscommandés (210, 212, 214) comprennent une pluralité de transistors montés en parallèle.

6. Circuit de variation de puissance (110) selon la revendication 5, dans lequel tous les transistors de la pluralité de transistors montés en parallèle sont de tailles différentes les uns par rapport aux autres.

7. Circuit de variation de puissance (110) selon la revendication 6, dans lequelles transistors de la pluralité de transistors montés en parallèle sont chacun d'une taille de différentes dimensions W/L, W étant une largeur de chaque transistor de la pluralité de transistors montés en parallèle et L étant une longueur de chaque transistor de la pluralité de transistors montés en parallèle.

8. Circuit de variation de puissance (110) selon la revendication 7, dans lequel le circuit de commande de variation (216) est adapté pour couper la pluralité de transistors montés en parallèle par ordre croissant de taille.

9. Circuit de variation de puissance (110) selon la revendication 5, dans lequel les transistors de ladite pluralité de transistors montés en parallèle comprennent chacun une borne de la grille couplée à un signal de commande de grille correspondant du circuit de commande de variation (216) et le circuit de commande de variation est adapté pour couper de manière séquentielle chaque transistor de ladite pluralité de transistors montés en parallèle.

10. Circuit de variation de puissance (110) selon la revendication 5, dans lequel les transistors de ladite pluralité de transistors montés en parallèle comprennent chacun une borne de la grille couplée à un circuit de commande de variation (216), ledit circuit de commande de variation comprenant un circuit diviseur de tension connecté entre une tension d'alimentation et un signal de commande analogique, le circuit diviseur de tension ayant des prises de tension chacune couplée à chaque transistor de la pluralité de transistors montés en parallèle.

**11.** Circuit de variation de puissance (110) selon la revendication 9, dans lequel ledit circuit de commande de variation (216) comprend

un convertisseur analogique/numérique (A/N) (300) destiné à fournir une sortie numérique correspondant à un signal de commande analogique, et

un décodeur numérique (302) destiné à couper de manière sélective chaque transistor de ladite pluralité de transistors montés en parallèle en réponse à la sortie numérique en provenance du convertisseur A/N.

**12.** Circuit de variation de puissance (110) selon la revendication 9, dans lequel ledit circuit de commande de variation (216) comprend

un compteur (304) destiné à fournir une sortie numérique correspondant aux fronts comptés d'un signal oscillant, et

un décodeur numérique (306) destiné à couper de manière sélective chaque transistor de ladite pluralité de transistors montés en parallèle en réponse à la sortie numérique en provenance du compteur.

**13.** Procédé de variation d'un signal de données comportant un courant de sortie au sein d'un émetteur-récepteur sans fil, ledit procédé comportant :

l'étape consistant à convertir un signal de tension de la bande de base d'entrée (IN) en un courant d'entrée correspondant ;

l'étape consistant à fournir ledit courant d'entrée à un transistor monté en diode (202) ;

l'étape consistant à refléter le courant d'entrée au moyen d'un transistor d'entrée (208) connecté en une configuration de miroir de courant avec le transistor monté en diode (202) ;

l'étape consistant à allumer chaque élément d'une pluralité d'éléments résistifscommandés (210, 212, 214) couplés entre une tension d'alimentation et une borne de la grille du transistor d'entrée (208) à des fins de minimalisation d'une intensité du courant de sortie fourni par une borne du drain du transistor d'entrée (208) qui correspond au signal de tension de la bande de base d'entrée ; et

l'étape consistant à couper de manière séquentielle chaque élément des éléments résistifs commandés (210, 212, 214) à des fins d'augmentation de l'intensité du courant de sortie fourni par la borne du drain du transistor d'entrée (208).

**14.** Procédé selon la revendication 13, dans lequel l'étape consistant à couper de manière séquentielle comprend

l'étape consistant à recevoir un signal de commande de variation (RAMP-CTRL),

l'étape consistant à convertir le signal de commande de variation en une sortie numérique (n), et

l'étape consistant à décoder la sortie numérique pour couper au moins l'un des éléments résistifs commandés (210, 212, 214).

**15.** Procédé selon la revendication 14, dans lequel le signal de commande de variation est un niveau de tension analogique varié et l'étape consistant à convertir comprend l'étape consistant à exécuter une conversion analogique/numérique (300) à des fins de fourniture de la sortie numérique correspondant au niveau de tension analogique à une fréquence prédéterminée.

**16.** Procédé selon la revendication 14, dans lequel le signal de commande de variation est un signal d'horloge oscillant et l'étape consistant à convertir comprend l'étape consistant à compter les fronts actifs du signal d'horloge oscillant au moyen d'un compteur (302) à des fins de fourniture de la sortie numérique correspondant à une valeur du compteur.

**17.** Procédé selon la revendication 13, dans lequel l'étape consistant à couper de manière séquentielle comprend

l'étape consistant à recevoir un signal de commande de variation analogique, et,

l'étape consistant à couper au moins deux des éléments résistifs commandés à différents taux et en même temps en réponse au signal de commande de variation.

100

110

IN ▶

Ramp

102

104

106

108

Figure 1

Figure 2

Figure 3

216 ⟍

300          302

RAMP_CTL ▶ ──── A/D converter ──n/── Decoder ──▶ to gate of 210
──▶ to gate of 212
•
•
•
──▶ to gate of 214

Figure 4

216 ⟍

304          306

RAMP_CTL ▶ ──── n-bit counter ──n/── Decoder ──▶ to gate of 210
──▶ to gate of 212
•
•
•
──▶ to gate of 214

Figure 5

Figure 6

Figure 7

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 5697072 A
- EP 0614269 A
- WO 03075484 A
- WO 0150632 A